# EUROPÄISCHE PATENTSCHRIFT

(11) **EP 0 928 423 B1**
(45) Veröffentlichungstag und Bekanntmachung des Hinweises auf die Patenterteilung: **05.07.2000**
(21) Anmeldenummer: 97909184.0
(22) Anmeldetag: 24.09.1997
(51) Int. Cl.: G01R 21/133

(54) **MESSEINRICHTUNG FÜR ELEKTRISCHE LEISTUNG UND VERFAHREN ZUR MESSUNG DER ELEKTRISCHEN LEISTUNG**
ELECTRICAL POWER MEASURING DEVICE AND METHOD
PROCEDE ET DISPOSITIF PERMETTANT DE MESURER LA PUISSANCE ELECTRIQUE

(30) Priorität: 25.09.1996 DE 19639410
(43) Veröffentlichungstag der Anmeldung: 14.07.1999
(73) Patentinhaber: SIEMENS AKTIENGESELLSCHAFT, 80333 München (DE)
(72) Erfinder: WINDSHEIMER, Klaus, D-91174 Spalt (DE)
(86) Internationale Anmeldenummer: DE9702164
(87) Internationale Veröffentlichungsnummer: WO9813699

(56) Entgegenhaltungen:
- EP-A- 0 377 282
- EP-A- 0 634 662
- EP-A- 0 681 235
- FR-A- 2 357 907
- GARVERICK S L ET AL: "A PROGRAMMABLE MIXED-SIGNAL ASIC FOR POWER METERING" IEEE JOURNAL OF SOLID-STATE CIRCUITS, Bd. 26, Nr. 12, 1.Dezember 1991, Seiten 2008-2015, XP000272862

## Beschreibung

Die Erfindung betrifft eine Meßeinrichtung für elektrische Leistung gemäß dem Oberbegriff des Anspruchs 1 (DE 26 30 359 C2) und ein Verfahren zur Messung der elektrischen Leistung.

Zur Bestimmung oder Messung von elektrischer Leistung eines elektrischen Verbrauchers ist es bekannt, die erfaßten Strom- und Spannungssignale am Verbraucher jeweils einem Analog-Digital-Wandler (AD-Wandler) zuzuführen und in einer nachfolgenden digitalen Verarbeitungseinrichtung miteinander zu multiplizieren. Dabei werden zeitgleiche Werte von Strom und Spannung miteinander verknüpft.

Zur Kompensation von Winkelfehlern, die beispielsweise von einem Shunt oder einem Stromwandler herrühren, kann dem AD-Wandler ein digitales Filter nachgeschaltet sein. Alternativ ist auch eine externe Kompensation mit einer RC-Beschaltung (analoges Filter) möglich. Eine derartige Meßeinrichtung benötigt einen hohen Aufwand an Bauteilen, wodurch sie im wesentlichen nur für hochwertige Zähler mit großer Genauigkeit in Frage kommt.

Aus der DE 26 30 359 C2 (entsprechend FR-A-2 357 907) ist eine Meßeinrichtung bekannt, bei der zur Kompensation einer Zeitverzögerung zwischen zwei Signalen ein analoges Zeitverzögerungsglied verwendet wird, das einem Multiplexer vorgeschaltet ist.

Aus der EP 0 681 235 A1 und der EP 0 634 662 A1 ist jeweils ein Elektrizitätszähler bekannt, bei dem für Strom und Spannung jeweils ein A/D-Wandler - wie bei der EP 0 377 282 A1 - verwendet wird. Der A/D-Wandler ist jeweils als Sigma-Delta-Wandler ausgebildet.

Aus der DE 195 21 609 A1 und der DE 195 21 610 A1 ist es im Zusammenhang mit der elektrischen Energiemessung bekannt, ein Dezimationsfilter anzuwenden, das ein wählbares Dezimationsverhältnis aufweist. Ein Hinweis auf die vorliegende Problematik ist dort nicht gegeben.

Der Erfindung liegt die Aufgabe zugrunde, eine einfache Meßeinrichtung und ein Verfahren anzugeben, bei der bzw. dem trotz geringem Bauteileaufwand eine möglichst hohe Meßgenauigkeit bei der Messung der elektrischen Leistung im Hinblick auf einen Winkelfehler gegeben ist. Bei der Meßeinrichtung soll der Bauteileaufwand gering gehalten sein.

Die Lösung der Aufgabe bezüglich der Meßeinrichtung gelingt erfindungsgemäß mit einer Meßeinrichtung gemäß den Merkmalen des Anspruchs 1.

Der Erfindung liegt der Grundgedanke zugrunde, daß ausgehend vom Stand der Technik ein Verarbeitungszweig mit einem AD-Wandler eliminiert werden kann, wobei als Ersatz dem verbleibenden Verarbeitungszweig ein Multiplexer vorgeschaltet wird. Dies hat jedoch zum Nachteil, daß die jeweiligen im Sinne von Wertepaare für einen zu bestimmenden Leistungswert vorgesehenen Abtastwerte von Strom und Spannung nicht mehr gleichzeitig sondern zeitlich nacheinander liegen.

Mit der vorliegenden Erfindung wird der Nachteil des zeitlichen Versatzes zur Kompensation von Winkelfehlern verwendet, wobei auf verblüffend einfache Weise eine Fehlerkompensation erzielt wird. Dabei ist eine Kompensation externer Winkelfehler gegeben, ohne daß zusätzliche Maßnahmen oder weitere Bauteile benötigt werden. Zusätzlich ist eine Einstellbarkeit der Winkelfehlerkompensation möglich.

Das verwendete Dezimationsfilter kann Teil der Verarbeitungseinrichtung oder des AD-Wandlers sein. Dies erlaubt eine Bildung von Multi-Bit-Datenwörtern, wodurch eine einfache digitale Meßwertbearbeitung mittels eines Rechners möglich ist. Dabei ist die Fehlerrate besonders gering.

Es ist günstig, wenn die Verarbeitungseinrichtung einen Mittelwertbildner umfaßt, dem die digitalen Werte eines der Eingangssignale zuführbar sind. Die gebildeten Ausgangsmittelwerte dienen dann mit den digitalisierten Werten des jeweils anderen Eingangssignals zur Bildung der jeweiligen Leistungswerte. Damit wird ein interner Winkelfehler, der sich aus einem Zeitversatz der Strom- und Spannungssignale ergibt, kompensiert.

Dies kann beispielsweise dadurch erfolgen, daß immer jeweils aufeinanderfolgende Strom- und Spannungswerte direkt miteinander multipliziert werden, wodurch eine Verdoppelung von Leistungswerten gegeben ist, die im Summe eine Mittelwertwirkung erzielen. Alternativ kann auch direkt der Mittelwert von beispielsweise zwei einem Stromwert benachbarten Spannungswerten gebildet werden, der dann mit dem Stromwert multipliziert wird.

Es ist günstig, wenn der AD-Wandler einen Sigma-Delta-Modulator umfaßt. Auf diese Weise ist eine einfache Bildung eines Digitalsignals möglich. Mit diesem Bauteil ist eine gute Linearität und große Stabilität in der Meßwertverarbeitung erzielbar.

Bevorzugt werden die Leistungswerte in der Verarbeitungseinrichtung zur Bildung zumindest eines Energiewertes akkumuliert. Dieser kann dann beispielsweise für eine Verrechnung gespeichert oder auch mit weiteren folgenden Energiewerten aufsummiert werden.

Die Meßeinrichtung ist bevorzugt eingesetzt bei Zählern für elektrische Energie und/oder Leistung, wobei selbstverständlich auch eine Integration in einer leittechnische Einrichtung zur Energiemessung denkbar ist. Eine bevorzugte Ausführung der Meßeinrichtung ist in einer Kombination der Ansprüche 1 bis 5 gegeben. Diese vereinigt alle Vorteile zur Kompensation externer und interner Winkelfehler.

Die Aufgabe bezüglich des Verfahrens wird erfindungsgemäß gelöst mit den Merkmalen des Anspruchs 6. Auf diese Weise ist eine einfache Kompensation eines Winkelfehlers mit einfachen technischen Mitteln möglich. Im übrigen gelten für das Verfahren die oben genannten Vorteile der Meßvorrichtung sinngemäß.

Mit Vorteil ist das serielle Signal ein Ausgangssignal eines Multiplexers. Dadurch ist die Verwendung eines besonders einfachen Bauteils möglich.

Es ist günstig, wenn das Ausgangssignal einer Analog-Digital-Wandlung unterzogen und dabei ein Digitalsignal erzeugt wird. Auf diese Weise ist eine einfache nachfolgende digitale Signalverarbeitung möglich. Bevorzugt ist das Digitalsignal als 1Bit-Strom ausgebildet. Hierdurch ist eine schnelle und fehlerarme Signalverarbeitung gegeben. lBit-AD-Wandler weisen eine einfache Analogschaltung auf, wobei eine Bildung von hochaufgelösten Digitalworten im Digitalteil gegeben ist.

Anschließend kann der 1Bit-Strom in Multi-Bitworte umgewandelt werden, so daß eine herkömmliche digitale Signalverarbeitung gegeben ist, bei der herkömmliche Bauteile, insbesondere digitale Signalprozessoren, zum Einsatz kommen.

Bei der Umwandlung des lBit-Stroms in Multi-Bitworte sind Wartetakte zwischen den Strom- und Spannungswerten vorgesehen, die eine vorgebbare Länge aufweisen. Auf diese Weise ist eine einstellbare Kompensation gegeben, wobei von gegebenenfalls ohnehin vorhandenen Wartetakten bei Dezimationsfiltern Gebrauch gemacht werden kann. In der Fachsprache wird hier auch von Wartezeiten gesprochen.

Bevorzugt werden die erzeugten Leistungswerte zur Bildung eines Energiewertes akkumuliert. Dadurch ist eine einfache Energieverbrauchsmessung gegeben.

Ausführungsbeispiele der Erfindung, weitere Vorteile, Ausgestaltungen und Details werden nachfolgend anhand der Zeichnung näher erläutert. Es zeigen:
- FIG 1: ein Blockschaltbild einer Leistungsmeßeinrichtung,
- FIG 2: ein Signaldiagramm in einer Prinzipdarstellung,
- FIG 3: eine weitere Leistungsmeßeinrichtung, und
- FIG 4: ein Blockdiagramm eines Dezimationsfilters gemäß FIG 3.

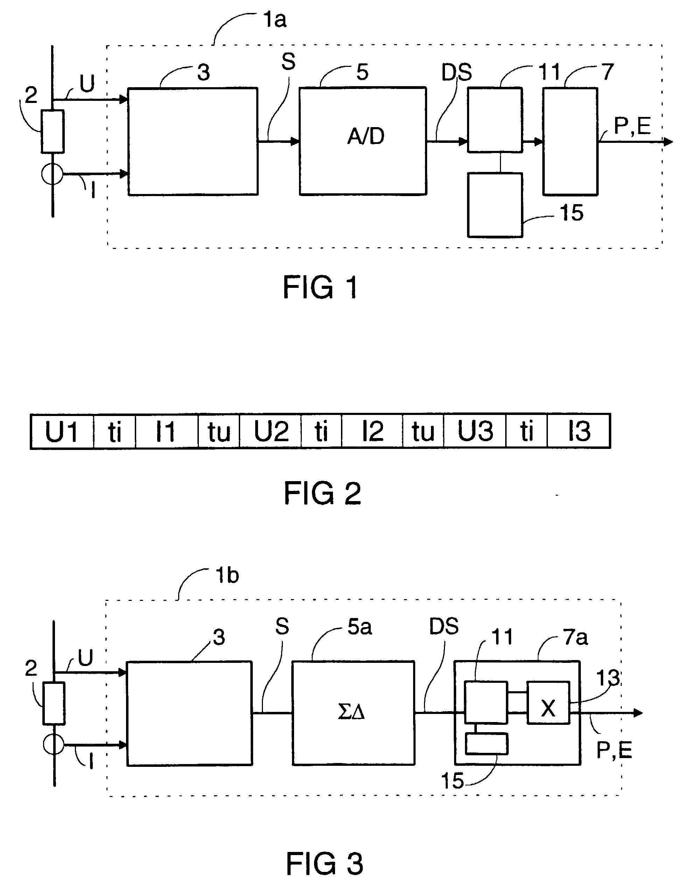

FIG 1 zeigt eine Meßeinrichtung la zur Messung der elektrischen Leistung (einphasig) in einer Prinzipdarstellung. Der Meßeinrichtung la sind von einem elektrischen Verbraucher 2 abgegriffene analoge Meßwerte oder Signale für einen Strom I und eine Spannung U als Eingangssignale zugeführt. Die beiden Eingangssignale I, U werden zunächst einem Multiplexer 3 zugeführt. Dieser erzeugt an seinem Ausgang ein serielles Signal S, in welchem die Werte des Strom- und des Spannungssignals U, I abwechselnd aufeinander folgen. Die dabei jeweils aufeinanderfolgenden Signalwertpaare sind im Hinblick auf den gewünschten Erfassungszeitpunkt zeitlich zueinander versetzt. Das serielle Signal S wird später noch näher erläutert.

Das serielle Signal S wird nachfolgend mit Hilfe eines Analog-Digital-Wandlers 5 in ein digitales Signal DS umgewandelt, das einem Dezimationsfilter zugeführt ist. Dem Dezimationsfilter 11 ist eine Steuerlogik 15 zugeordnet. In einer dem Dezimationsfilter 11 nachgeschalteten digitalen Verarbeitungseinrichtung 7 werden die jeweiligen digitalisierten Werte vom Strom- und vom Spannungssignal I bzw. U zu Leistungswerten P multipliziert, die dann am Ausgang für eine weitere Verarbeitung zur Verfügung gestellt werden. Gegebenenfalls kann auch innerhalb der Verarbeitungseinrichtung 7 eine weitere Verarbeitung der digitalisierten Werte vom Strom- und vom Spannungssignal I und U, z.B. eine Akkumulierung, vorgesehen sein, so daß Energiewerte E gebildet werden.

Die Verarbeitungseinrichtung 7 ist bevorzugt als Rechner, z.B. mit einem Mikrocomputer, und/oder als digitaler Signalprozessor ausgebildet. Die am Ausgang anstehenden Leistungs- oder Energiewerte P bzw. E können beispielsweise für eine Weitergabe an eine Registriereinrichtung oder eine sonstige leittechnische Einrichtung - auch für eine Fernablesemöglichkeit oder eine Anzeigevorrichtung - weitergegeben werden. Speziell kann die Leistungsmeßeinrichtung 1a auch Teil eines Elektrizitätszählers sein.

Die Darstellung gemäß FIG 2 zeigt nähere Details zur Signalverarbeitung. Gezeigt ist dabei ein Ausschnitt des dem Dezimationsfilter 11 zugeführten digitalen Signals DS, wobei aufeinanderfolgend Strom- und Spannungswerte I bzw. U gezeigt sind. Jeweils benachbarte Strom- und Spannungswerte I bzw. U sind, wie bereits oben erwähnt, zeitlich zueinander versetzt. Mit I1 bis I3 bzw. U1 bis U3 sind zeitlich nacheinander folgende Werte gemeint. Bei der direkten Multiplizierung dieser Werte miteinander im Sinne von Strom-Spannungspaaren (z.B. I1 x U1, I2 x U2 usw.) würde sich, wie bereits oben beschrieben, ein Winkelfehler ergeben.

Eine erste Möglichkeit einer Fehlerkompensation interner Winkelfehler ist dadurch erzielt, daß immer jeweils aufeinanderfolgende Strom- und Spannungswerte (beispielsweise die Werte U1 und I1, I1 und U2, U2 und I2 usw.) miteinander multipliziert werden. Es wird also quasi eine doppelte Anzahl von Leistungswerten erzeugt, die zwar jeweils eine Ungenauigkeit oder einen Winkelfehler beinhalten, jedoch in Summe eine Mittelwertbildung erzielen, wodurch ein Kompensation eines internen Winkelfehlers, z.B. bedingt durch den Multiplexer, gegeben ist.

Eine zweite Möglichkeit der Fehlerkompensation ist durch eine direkte Mittelwertbildung gegeben. Es wird dazu beispielsweise von U1 und U2 der Mittelwert gebildet, d.h. ([U1+U2]/2), der dann zur Leistungsberechnung mit dem Stromwert I1 multipliziert wird. Es sind auch noch weitere Möglichkeiten einer einfachen Mittelwertbildung realisierbar. Die Mittelwertbildung erfolgt in der digitalen Verarbeitungseinrichtung 7, die hierzu einen geeigneten Mittelwertbildner, beispielsweise einen Programmbaustein, umfaßt.

FIG 3 zeigte eine weitere Leistungsmeßeinrichtung 1b in einer detaillierten Darstellung. Hier umfaßt der Analog-Digital-Wandler 5a einen Sigma-Delta-Modulator ΣΔ, der an seinem Ausgang als digitales Signal DS einen 1Bit-Strom erzeugt.

Die nachfolgende digitale Verarbeitungseinrichtung 7a umfaßt ein Dezimationsfilter 11 und eine nachgeschaltete Multipliziereinrichtung 13. Das Dezimationsfilter 11 dient zur Umwandlung des 1Bit-Stromes in Multi-Bitworte. Multi-Bitworte lassen sich besonders einfach von digitalen Signalprozessoren oder Mikrocomputern verarbeiten. Dies gilt insbesondere für die Realisierung der nachgeschalteten Multipliziereinrichtung 13. Diese arbeitet nach der bereits oben beschriebenen Verfahrensweise.

Dem Dezimationsfilter 11 ist eine Steuerlogik 15 zugeordnet, mit der eine Einstellbarkeit der Umwandlung des lBit-Stromes in Multi-Bitworte gegeben ist.

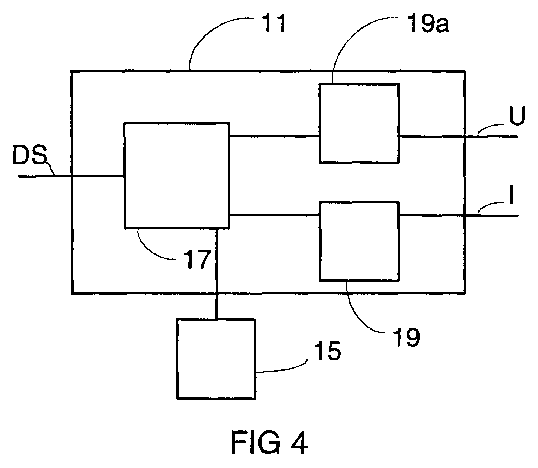

Zwischen den in FIG 2 dargestellten Strom- und Spannungswerten I bzw. U sind jeweils Zeitabschnitte, Wartezeiten oder Wartetakte ti und tu eingefügt. Die Einfügung wird dabei von der Steuerlogik 15 bewirkt. Die Wartetakte ti, tu sind prinzipiell zur Vermeidung von Überkopplungen zwischen aufeinanderfolgender Werte, insbesondere den Werten von Strom und Spannung, vorgesehen. In der Praxis sind diese Wartetakte ti, tu dadurch realisiert, daß nach der Bildung eines Digitalwertes - oder besser: eines Multi-Bitwortes, im Dezimationsfilter 11 der dortige nicht näher gezeigte interne Multiplexer umgeschaltet und das Dezimationsfilter 11 für die Wartezeit zurückgesetzt wird. Es werden also sogenannte "wait states" erzeugt. Hierzu wird auch auf die Ausführungen zur FIG 4 verwiesen.

Diese Wartetakte ti, tu werden vorliegend vorteilhaft genutzt. Die Wartetakte ti, tu sind nämlich einstellbar ausgeführt. Diese Einstellbarkeit ist parametrierbar, z.B. zwischen 1 und 128 Takten. Die Wartezeit tu zwischen Strom I1 und nachfolgender Spannung U2 ist mit beispielsweise nur wenigen Takten, z.B. 6 Takten, fest eingestellt. Durch die geeignete Wahl der Wartetakte ti zwischen Spannung U2 und nachfolgendem Strom I2 kann ein Phasenwinkel erzeugt und damit ein Winkelfehler kompensiert werden. Dies gilt insbesondere für Wandlerfehler, wie sie z.B. bei der Meßwerteerfassung auftreten und auf diese Weise hervorragend ausgeglichen werden können.

Bei der vorliegenden Meßeinrichtung 1a, 1b sind nur wenige Bauteile erforderlich. Bei einer Ausführung als ASIC ist eine nur geringe Chipfläche erforderlich. Der Stromverbrauch ist sehr gering. Auch sind Modulationsüberkopplungen über die Versorgungsspannung oder über das Substrat des ASICs gering gehalten.

FIG 4 zeigt eine mögliche Ausführung des Dezimationsfilters 11 im Detail. Es umfaßt im wesentlichen einen Multiplexer 17, dem an seinen Ausgängen jeweils ein Hochpaßfilter 19a bzw. 19b für den jeweiligen Wert von Strom bzw. Spannung zugeordnet ist. An den Ausgängen stehen dann die jeweils erzeugten Multi-Bitwerte wie oben beschrieben an.

Selbstverständlich sind die aufgezeigten Meßeinrichtungen auch für die Verarbeitung weiterer Signale, z.B. für die Verarbeitung zusätzlicher Temperatursignale, oder für eine mehrphasige Signalverarbeitung, z.B. für Drehstrom, geeignet, wobei auch für die weiteren Signale eine Kompensation durch eine Wartezeitparametrierung nach der oben beschriebenen Art vorgesehen sein kann. Grundsätzlich ist auch eine alternative Kompensation durch eine veränderliche Fensterbreite im Dezimationsfilter 11 denkbar, wodurch prinzipiell ebenfalls ein Phasenwinkel im oben beschriebenen Sinne erzeugbar ist. Hierbei sind ggf. weitere schaltungstechnische oder verfahrenstechnische Maßnahmen erforderlich sein.

Die aufgezeigten Meßeinrichtungen eignen sich insbesondere für eine Anwendung bei Elektrizitätszählern zur Messung der elektrischen Energie, z.B. bei ein- oder mehrphasigen Haushaltszählern. Selbstverständlich sind einzelne Merkmale der verschiedenen Ausführungen im Rahmen des fachmännischen Könnens vorteilhaft miteinander kombinierbar, ohne daß der Grundgedanke der Idee verlassen wird. Wesentlich hierfür ist, daß mittels einer Mittelwertbildung eine Interpolation erzielt ist, die zur Kompensation interner Winkelfehler dient. Weiterhin ist eine einstellbare Winkelfehlerkompensation durch die variable Wartezeit zwischen den Strom- und Spannungswerten gegeben, durch die auch externe Winkelfehler berücksichtigt sind.

## Patentansprüche

1. Meßeinrichtung (1a,1b) für elektrische Leistung mit:
- einem Multiplexer (3), dem als Eingangssignale ein Strom- und ein Spannungssignal (I bzw. U) zuführbar sind,
- einem dem Multiplexer (3) nachgeschalteten Analog-Digital-Wandler (5,5a),
- einer dem Analog-Digital-Wandler (5,5a) nachgeschalteten digitalen Verarbeitungseinrichtung (7, 7a), der digitalisierte Werte des Strom- und des Spannungssignals (I1 bis U3) zuführbar sind und
- einer Steuerlogik (15), welche jeweils zwischen den gewandelten Werten von Strom- und Spannung (I1 bis U3) vorgebbare Wartetakte (ti bzw. tu) erzeugt,
**dadurch gekennzeichnet**, daß
- der Analog-Digital-Wandler (5,5a) als Sigma-Delta-Modulator (ΣΔ) ausgebildet ist, welcher an seinem Ausgang ein digitales serielles Signal (S) führt,
- zwischen Sigma-Delta-Modulator (ΣΔ) und digitaler Verarbeitungseinrichtung (7, 7a) ein Dezimationsfilter (11) geschaltet ist und
- die Steuerlogik (15) dem Dezimationsfilter (11) zugeordnet ist und dieses so ansteuert, daß jeweils zwischen den zur Bildung von jeweiligen Leistungswerten (P, P1 bis P3) digitalisierten Werten von Strom- und Spannung (I1 bis U3) vorgebbare Wartetakte (ti bzw. tu) erzeugt sind, derart, daß ein vorgegebener Phasenwinkel zwischen den digitalisierten Werten (I1 bis U3) vom Strom- und vom Spannungssignal (I bzw. U) erzeugt ist.

2. Meßeinrichtung nach Anspruch 1, wobei die digitale Verarbeitungseinrichtung (7, 7a) einen Mittelwertbildner umfaßt, dem die digitalisierten Werte (I1 bis I3 oder U1 bis U3) des Strom- oder Spannungssignals (I bzw. U) zuführbar sind, und dessen Ausgangsmittelwerte zum Bilden der Leistungswerte (P, P1 bis P3) mit den digitalen Werten des jeweils anderen Eingangssignals dienen.

3. Meßeinrichtung nach Anspruch 2, wobei die Ausgangsmittelwerte von den digitalisierten Werten der Spannung (U1 bis U3) gebildet sind.

4. Meßeinrichtung nach einem der Ansprüche 1 bis 3, wobei die Leistungswerte (P, P1 bis P3) in der digitalen Verarbeitungseinrichtung (7, 7b) zur Bildung zumindest eines Energiewertes (E) akkumuliert werden.

5. Meßeinrichtung nach einem der Ansprüche 1 bis 4, welche als Elektrizitätszähler dient.

6. Verfahren zur Messung von elektrischer Leistung (P) an einem Verbraucher (2), wobei
- fortlaufend Strom- und Spannungswerte (I1 bis U3) eines Strom- beziehungsweise Spannungssignals (I bzw. U) erfaßt werden,
- mittels Multiplexen ein gemeinsames serielles Signal (S) erzeugt wird, in welchem die Strom- und Spannungswerte (I1 bis U3) abwechselnd aufeinanderfolgen,
- das serielle Signal (S) mittels einer Analog-Digital-Wandlung in einen 1-Bit-Strom (DS) gewandelt wird,
- mittels eines Dezimationsfilters (11) zwischen den abgetasteten Strom- und Spannungswerten (I1 bis U3) im 1-Bit-Strom (DS) jeweils Wartetakte (ti bzw. tu) vorgebbarer Länge zur Bildung einer Winkelverschiebung erzeugt werden,
- der 1-Bit-Strom (DS) anschließend in Multi-Bitworte umgewandelt wird und
- jeweils direkt aufeinanderfolgende Strom- und Spannungswerte (I1 bis U3) anschließend zur Bildung von jeweiligen Leistungswerten (P, P1 bis P3) jeweils verwendet und gegebenenfalls direkt miteinander multipliziert werden.

7. Verfahren nach Anspruch 6, wobei die jeweiligen Leistungswerte (P1 bis P3) zur Bildung eines Energiewertes (E) akkumuliert werden.

## Claims

1. Measuring device (1a, 1b) for electrical power, having
- a multiplexer (3), to which a current signal and a voltage signal (I and U respectively) can be supplied as input signals,
- an analog-to-digital converter (5, 5a) connected downstream of the multiplexer (3),
- a digital processing device (7, 7a) connected downstream of the analog-to-digital converter (5, 5a), to which digital processing device digitised values of the current signal and voltage signal (I1 to U3) can be supplied, and
- a control logic (15), which generates between each of the converted values of current and voltage (I1 to U3) predeterminable waiting cycles (ti and tu respectively),
characterised in that
- the analog-to-digital converter (5, 5a) is constructed as a sigma-delta modulator (ΣΔ), which carries at its output a digital serial signal (S),
- connected between the sigma-delta modulator (ΣΔ) and the digital processing device (7, 7a) is a decimation filter (11), and
- the control logic (15) is assigned to the decimation filter (11) and controls the latter in such a way that there are generated between each of the values of current and voltage (I1 to U3), which are digitised in order to form respective power values (P, P1 to P3), predeterminable waiting cycles (ti and tu respectively), in such a way that a predetermined phase angle between the digitised values (I1 to U3) of the current signal and voltage signal (I and U respectively) is generated.

2. Measuring device according to claim 1, wherein the digital processing device (7, 7a) comprises an averaging unit, to which the digitised values (I1 to I3 or U1 to U3) of the current signal or voltage signal (I and U respectively) can be supplied, and the output average values of which are used to form the power values (P, P1 to P3) with the digital values of the respective other input signal.

3. Measuring device according to claim 2, wherein the output average values are formed by the digitised values of the voltage (U1 to U3).

4. Measuring device according to one of claims 1 to 3, wherein the power values (P, P1 to P3) are accumulated in the digital processing device (7, 7b) in order to form at least one energy value (E).

5. Measuring device according to one of claims 1 to 4, which is used as an electricity meter.

6. Method for measuring electrical power (P) at a load (2), wherein
- current values and voltage values (I1 to U3) of a current signal and voltage signal respectively (I and U respectively) are continuously acquired,
- by means of multiplexion, a common serial signal (S) is generated, in which the current values and voltage values (I1 to U3) follow each other in an alternating manner,
- the serial signal (S) is converted by means of an analog-to-digital conversion into a 1-bit data stream (DS),
- by means of a decimation filter (11), there are generated between the sampled current values and voltage values (I1 to U3) in the 1-bit steam (DS) respective waiting cycles (ti and tu respectively) of predeterminable length in order to form a phase displacement,
- the 1-bit stream (DS) is then converted into multi-bit words and
- respectively directly successive current values and voltage values (I1 to U3) are then used in each case in order to form respective power values (P, P1 to P3) and possibly multiplied directly with each other.

7. Method according to claim 6, wherein the respective power values (P1 to P3) are accumulated in order to form an energy value (E).

## Revendications

1. Dispositif (1a, 1b) de mesure de la puissance électrique comportant :
- un multiplexeur (3) auquel peuvent être envoyés comme signaux d'entrée un signal (I) de courant et un signal (U) de tension;
- un convertisseur (5, 5a) analogique-numérique monté en aval du multiplexeur (3),
- un dispositif (7, 7a) de traitement numérique, qui est monté en aval du convertisseur (5, 5a) analogique-numérique et auquel peuvent être envoyées des valeurs numérisées du signal (I1 à U3) du courant et de la tension et
- une logique (15) de commande, qui produit chaque fois des cycles d'attente pouvant être prescrits entre les valeurs converties de courant et de tension (I1 à U3),
caractérisé en ce que
- le convertisseur (5, 5a) analogique-numérique est réalisé en modulateur (ΣΔ) Sigma-Delta qui envoie à sa sortie un signal (S) sériel numérique,
- un filtre (11) décimétrique est branché entre le modulateur (ΣΔ) Sigma-Delta et le dispositif (7, 7a) de traitement numérique et
- la logique (15) de commande est associée au filtre (11) décimétrique et ce dernier est commandé de manière à produire chaque fois entre les valeurs numérisées de courant et de tension (I1 à U3) numérisées pour la formation de valeurs (P, P1 à P3) de puissance associée, des cycles (ti et tu) d'attente pouvant être prescrits, de telle manière qu'il est produit un angle de phase prescrit entre les valeurs (I1 à U3) numérisées du signal (I) de courant et du signal (U) de tension.

2. Dispositif de mesure suivant la revendication 1, le dispositif (7, 7a) de traitement numérique comprenant un générateur de valeurs moyennes auquel peuvent être envoyées les valeurs (I1 à I3 ou U1 à U3) numérisées du signal (I) de courant ou du signal (U) de tension, et dont les valeurs moyennes de sortie servent à former les valeurs (P, P1 à P3) de puissance avec les valeurs numériques de l'autre signal d'entrée.

3. Dispositif de mesure suivant la revendication 2, les valeurs moyennes de sortie étant formées par les valeurs numérisées de la tension (U1 à U3).

4. Dispositif de mesure suivant l'une des revendications 1 à 3, les valeurs (P, P1 à P3) de puissance étant accumulées dans le dispositif (7, 7b) de traitement numérique en vue de la formation d'au moins une valeur (E) d'énergie.

5. Dispositif de mesure suivant l'une des revendications 1 à 4, qui sert de compteur d'électricité.

6. Procédé de mesure de la puissance (P) électrique sur un appareil (2) utilisateur,
- des valeurs de courant et des valeurs de tension (I1 à U3) d'un signal (I) de courant et d'un signal (U) de tension étant détectées en continu,
- un signal (S) sériel commun étant produit au moyen d'un multiplexage, les valeurs (I1 à U3) de courant et de tension se succédant en alternance dans le signal,
- le signal (S) sériel étant converti en un courant (DS) à 1 bit au moyen d'une conversion analogique-numérique,
- des cycles (ti à tu) d'attente de longueurs prescrites étant, pour former un décalage angulaire, produits au moyen d'un filtre (11) décimétrique entre les valeurs échantillonnées de courant et de tension (I1 à U3) dans le courant (DS) à 1 bit,
- le courant (DS) à 1 bit étant ensuite converti en mots multibits et
- des valeurs (I1 à U3) de courant et de tension qui se succèdent directement étant utilisées ensuite pour former des valeurs (P, P1 à P3) de puissance associée et étant éventuellement multipliées directement les unes par les autres

7. Procédé suivant la revendication 6 les valeurs (P1 à P3) de puissance associée étant pour former uns valeur (E) d'énergie
